Europäisches Patentamt

European Patent Office

Office européen des brevets

(11) Publication number: **0 090 900**
**B1**

# EUROPEAN PATENT SPECIFICATION

(45) Date of publication of patent specification: **11.02.87**

(51) Int. Cl.⁴: **H 05 K 3/42**

(21) Application number: **82400623.3**

(22) Date of filing: **05.04.82**

(54) **Process of manufacturing printed wiring boards and printed wiring boards manufactured by the same.**

(43) Date of publication of application:
**12.10.83 Bulletin 83/41**

(45) Publication of the grant of the patent:
**11.02.87 Bulletin 87/07**

(84) Designated Contracting States:
**DE FR IT NL**

(56) References cited:
**FR-A-2 232 908**
**GB-A- 829 263**
**GB-A-1 396 481**
**GB-A-2 057 774**

**I. Electrochen. Soc. Vol. 120 No. 4 April 1973**
**pages 502-508 RL. Cohen & K.W. West**
**I. Elektrochem. Soc. Vol. 119, No. 4 April 1972**
**pages 433-438**

(73) Proprietor: **KANTO KASEI CO., LTD.**
**No. 73, Ikeda-cho 4-chome**
**Yokosuka-shi Kanagawa-ken (JP)**

(72) Inventor: **Nishihara, Haruo**
**No. 6-21, Uragaoka 2-chome**
**Yokosuka-shi Kanagawa-ken (JP)**
Inventor: **Suzuki, Yoshiaki**
**No. 28-4, Kurihama 7-chome**
**Yokosuka-shi Kanagawa-ken (JP)**

(74) Representative: **Polus, Camille et al**
**c/o Cabinet Lavoix 2, Place d'Estienne d'Orves**
**F-75441 Paris Cedex 09 (FR)**

## Description

### 1. Field of the invention

This invention relates to the process of manufacturing printed wiring boards suitably used for business, communication and electric machine and tools and printed wiring boards manufactured by the same.

### 2. Description of the prior art

The conventional processes of manufacturing printed wiring boards called copper through-hole printed wiring boards have been roughly classified into two methods such as the subtractive process wherein the printed wiring board is made from the copper-clad laminate and the additive process wherein the printed wiring board is made from the copper foil laminate-free catalyst included laminate. As examples of the former there are enumerated (1) the so-called tenting process which comprises the steps of making holes; plating through holes; thereafter copper plating said hole walls and copper foil to the thickness required for the hole wall by electrolysis; pouring ink in the hole walls for forming an etching resist film on necessary circuits; thereafter removing the copper foil on the unnecessary portion by etching; and then removing the etching resist film and (2) the modified process as disclosed in Japanese Laid-open Patent Application 54-13965 which comprises the steps of making necessary circuits by etching; thereafter making holes; forming a pretreating layer on said hole walls and circuits by electroless plating; mechanically removing said pretreating layer on circuits; forming a solder resist film on the necessary portion; and thereafter forming an electroless plated film on the hole walls and necessary circuits; or making holes after the solder resist film is formed. And, as the example of the latter additive process there is cited (3) the process which comprises the steps of applying a bonding agent onto a catalyst included laminate; thereafter making holes; forming a permanent resist film on the portion other than circuits; then forming copper on the hole walls and circuits by electroless plating; and thereafter forming a solder resist film on the necessary portion. However, these conventional process include various shortcomings in the respects of quality and productivity. This will be explained concerning each example of the above mentioned process. The process example (1) is defective in that it takes a long period of time to remove the copper on the unnecessary portions by etching because the thickness of said copper, which comprises the thickness of copper foil and that of through-hole plating, is nearly twice that of copper foil, and therefore circuits must be undercut largely with the result of deteriorated dimensional accuracy. The process example (2) is defective in that since circuits are formed by etching, thereafter a layer is formed on the hole wall portions and solder resist film or on the copper foil-melted off, naked laminate by pretreatment for electroless plating, then the layer formed on circuits by pretreatment for electroless plating are mechanically removed and thereafter electroless plating is conducted, it is difficult to completely remove the layer formed by pretreatment for electroless plating and therefore the plated layer remaining on the unnecessary portions brings about short circuits or deteriorates the insulation resistance between circuits. And, the process example (3) is defective in that as there is necessity of using the special and expensive base material, namely the catalyst included laminate, it is not only expensive but also unsuitable for common use, and further as plating is made on permanent resist-formed circuits, the dimensional accuracy of circuits is inferior, that is this process is unsuitable for circuits being less than 0.5 mm in width and the formed circuits are liable to lack uniformity in width.

GB—A—1 396 481 discloses a process comprising the steps of providing holes in a metal clad board; sensitizing at least the surface of the a metal clad board; sensitizing at least the surface of the holes; coating the metal on the board with an etching resist material in a desired circuit pattern; etching away the metal not covered by the resist; removing the resist from the board, and electroless metal plating the surface of at least the holes. In the sensitizing step palladium metal is adsorbed onto the surface of the metal foil as well as the surface of the holes. However, in this process, the palladium adsorbed on the surface of the metal foil is removed in the etching step. That is, the palladium metal adsorbed on to the wall portions of the holes are removed by the etching treatment.

GB—A—2 057 774 discloses a process comprising steps of boring or punching a copper-laminated substrate material; activating all the surfaces by means of an activator; reducing by using a reducing agent; the surface is then treated in the usual manner.

More specifically the process comprises two successive steps, namely an activating step using an activator, preferably an aqueous alkaline solution of a palladium complex, especially palladium sulphate with 2-aminopyridine, and a reducing step using a reducing agent, for example sodium diethylamino-borane.

In both these processes the palladium metal or reduced palladium complex formed on the copper laminated substrate is removed in the etching step.

Further Pd-Sn sensitizers for electroless plating are disclosed by Cohen and West in J. Electrochem. Soc. *1199*, 433 (1972), and *120*, 502 (1973).

### Summary of the invention

It is an object of this invention to obtain a highly accurate and cheap printed wiring board which is capable of removing the above mentioned short-comings inherent in conventional processes and completely free from dangers of bad insulation resistance between circuits and short-circuit accidents without using any special base material at all. This object can be achieved by making holes in the necessary portion of a copper-clad laminate; forming a colloidal catalytic layer on said hole walls and copper cladding; forming an etching resist film on necessary lands, wiring and circuits; removing the copper cladding on the unnecessary portion by etching; removing the etching resist film; activating the colloidal catalytic layer as pretreatment for electroless plating; and forming an electroless plated film of copper or nickel on the catalytic layer formed on the hole walls, lands wiring and circuits, or forming an electroless plated film of copper or nickel on the catalytic film formed on the hole walls without removing the etching resist film.

It is another object of this invention to obtain a printed wiring board which is capable of ensuring reliability for a long period of time by preventing circuits from bridging at the time of plating parts and/or protecting the surfaces of circuits and insulating material from moisture and the like.

This object can be achieved by forming a solder resist film on the necessary portion before or after said electroless plated film is formed in the above mentioned process.

The other objects of this invention will be clearly understood from the subsequent explanation.

Brief description of the drawings

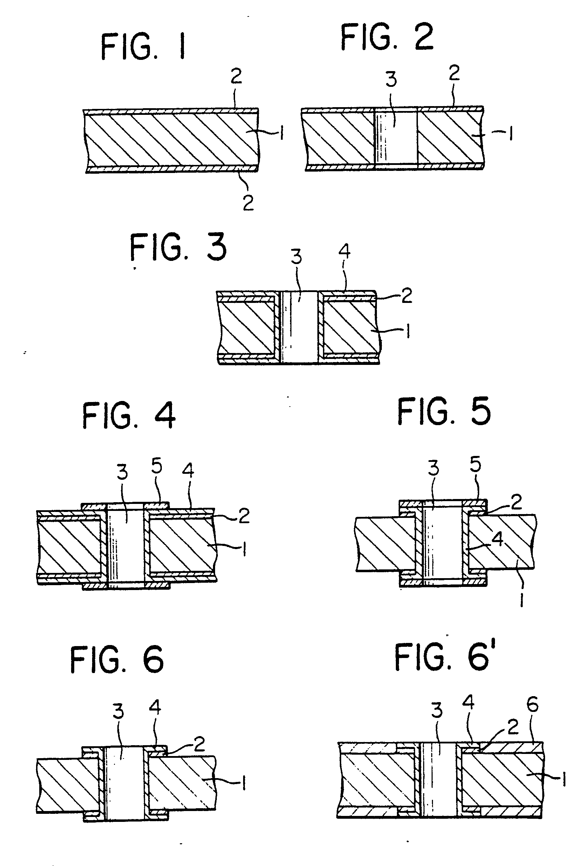

Fig. 1 to Fig. 8 are cross-sectional views illustrating the process of manufacturing a through-hole printed wiring board by using this invention.

Detailed description of the invention

One example of the process of manufacturing a printed wiring board according to this invention will be explained hereinafter with reference to the accompanying drawings.

First, holes 3 are made in the necessary portion of a conventional copper-clad laminate which comprises laminating a copper foil 2 on an insulating material 1 as shown in Fig. 1 (Fig. 2). These holes may be perforated by using a drill or punch. Then, a conventional pretreatment for electroless plating is performed. For example, this laminate is dipped in an alkali defatted liquid so as to clean the surfaces of copper foil and hole walls, thereafter is dipped in a 5 vol % hydrochloric acid aqueous solution to activate the copper foil surface, and then is dipped in an aqueous solution, the so-called catalyzer, containing 15 g/l ionic concentration of dihydric tin comprising stannous chloride, palladium chloride and hydrochloric acid, 0.25 g/l ionic concentration of dihydric palladium and 200 ml/l of concentrated hydrochloric acid so as to form a tin-palladium colloid type catalytic layer 4 (Fig. 3). Then, the surface on which the catalytic layer 4 has been formed by adsorption is subjected to forced or natural drying so as to have a sufficient adhesive property for an etching resist film, and thereafter an etching resist film 5 is formed on the necessary portion (Fig. 4). In this instance, said etching resist may be either ink or a dry film, and its formation may be made by means of either a printing process or a photographic process. Thereafter, the copper foil on the unnecessary portion is removed with a solution comprising 400 g/l of ferric chloride and 3 g/l of hydrochloric acid or the like (Fig. 5). In this instance, the catalytic layer adsorbed on the copper foil is completely removed simultaneously with removing of the copper foil by etching. Consequently, the catalytic layer formed by pretreatment for electroless plating does no longer exist on the surface of the copper foil removed insulating material 1, but the catalytic layer formed on the inside wall of the through hole is not removed and retained because it is adsorbed directly on the insulating plate. This is the most marked characteristic of this invention. Due to this, electroless plating may not deposit on anywhere other than the necessary portion during the subsequent circuit forming process and further any deterioration in insulation resistance may be caused no longer between the circuits. In this connection, it is to be noted that a known solution of ammonium persulfate or an alkali etchant may be used for etching purposes. Next, the etching resist film 5 having now become useless is removed in the usual manner by using trichlene or methylene dichloride (Fig. 6). Then, a solder resist film is formed on the necessary portion for preventing the circuits from bridging or protecting the surfaces of circuits and insulating material from steam and the like at the time of solder parts (Fig. 6'). This solder resist film has recently become indispensable for industrial printed wiring boards in order to secure the long reliability of printed wiring boards, and is regarded as important especially in the case of the so-called copper through-hole printed wiring board according to this invention. The solder resist is generally formed with an epoxy type ink, but may be formed with a liquid or dry photosensitive resin film.

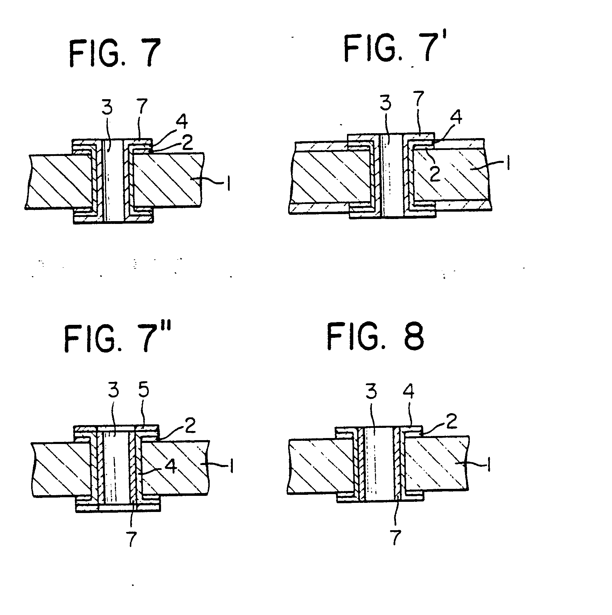

Next, the laminate is dipped for example in a 10% sulfuric acid solution for activating the catalytic layer 4 adsorption-formed on the surfaces of copper foil covering hole walls and necessary circuits by pretreatment for electroless plating so that the reactivity of electroless copper plating may be displayed perfectly in the succeeding step. Then, the laminate is dipped in an electroless copper plating bath so as to form an electroless copper plated film 7 on the wall surfaces of holes 3 in the catalytic layer 4 formed by electroless plating reaction and the surface of copper foil 2 on necessary circuits (Fig. 7'). One example of the bath composition and the plating condition of this electroless copper plating, will be given as follows. The following composition and condition may be used effectively for high-speed plating:

| Sodium ethylene diamine tetracetate | 40 g/l |
|---|---|
| Copper sulfate $(CuSO_4 \cdot 5H_2O)$ | 10 g/l |
| Paraformaldehyde | 10 g/l |
| Sodium cyanide | 100 ppm |
| pH | 12 |
| Temperature | 60°C |

And, the following composition and condition may be used effectively for low-speed plating:

| Rochelle salt | 40 g/l |
|---|---|
| Copper sulfate | 10 g/l |
| Paraformaldehyde | 15 g/l |
| Sodium hydroxide | 8 g/l |
| Sodium cyanide | 100 ppm |
| Temperature | 25°C |

The thus obtained electroless copper plated film 7, as stated previously, is formed with a strong adhesive strength selectively only on the catalytic layer formed on the wall surface portions of holes 3, lands and circuits and therefore is never formed on the other unnecessary portions at all. Fig. 7' shows the board prepared through the steps which have been described up to here, that is the finished printed wiring board according to this invention. In this connection, it is to be noted that the solder resist film may be formed prior to the electroless plating as shown in Fig. 6' and finished as shown in Fig. 7', but said film may be formed after the electroless plating has been applied as shown in Fig. 7 and thereafter finished as shown in Fig. 7'. When the solder resist film 6 is needless, electroless plating may be applied directly onto the board as shown in Fig. 6, and the same may be finished as shown in Fig. 7.

In this instance, the etching resist film 5 may be subjected to electroless copper plating treatment without being removed. In this case, the etching resist film 5 is retained on the circuits and lands, and consequently the electroless copper plated film is formed only on the catalytic layer 4 exposed on the hole wall portion (Fig. 7"). This etching resist film is removed in the usual manner after the electroless copper plated film has been formed (Fig. 8). However, this etching resist film 5 may be retained as shown in Fig. 7" without being removed. This permits the etching resist film 5 to remain on the circuits and lands, and said remaining film 5 performes the same operation as the solder resist film 6, thereby protecting the circuits and lands from moisture and the like.

When comparing the printed wiring board obtained according to this invention with those obtained according to the conventional manufacturing processes in respect of the performance and cost, the results obtained therefrom can be summarized as shown in the following table.

| | Our process | Conventional processes | | |
|---|---|---|---|---|
| | | Example (1) | Example (2) | Example (3) |
| Base material used | cheap | cheap | cheap | expensive |
| Time required for manufacturing | short | short | short | long |
| Probable minimum circuit width | 0.1 mm | 0.3 mm | 0.2 mm | 0.5 mm |
| Intercircuit insulation resistance | $10^{12}$—$10^{13}\Omega$ | $10^{12}$—$10^{13}\Omega$ | $10^7$—$10^8\Omega$ | $10^{12}$—$10^{13}\Omega$ |
| Danger of short circuits | none | none | exist | exist |
| Soldering rate | 100% | 80% | 80% | 60% |
| Solder resist forming accuracy | easy | easy | difficult | easy |

It is needless to say that this invention is concerned with the process for manufacturing through holes and circuits with an electroless copper plated film, but said through holes and circuits may be formed by using electroless nickel plating.

# 0 090 900

## Claims

1. A process of manufacturing a printed wiring and circuit board comprising the steps of: making holes in the necessary portion of a copper-clad laminate; forming a colloidal catalytic layer on said hole walls and copper cladding; forming an etching resist film on necessary lands, wiring and circuit; removing the copper cladding on the unnecessary portion by etching; removing the etching resist film; activating the colloidal catalytic layer as a pretreatment for electroless plating; and forming an electroless plated film of copper or nickel on the activated catalytic layer formed on the hole walls, lands, wiring and circuits.

2. A process as claimed in claim 1 wherein said electroless plated film is formed on the catalytic layer formed on the hole walls after etching has been effected and without removing the etching resist film.

3. A process as claimed in claim 2 wherein the etching resist film is removed after the electroless plated film has been formed.

4. A process as claimed in any one of claim 1 to claim 3 wherein a solder resist film is formed on the necessary portion before or after the electroless plated film has been formed.

5. A process as claimed in any one of claim 1 to claim 4 wherein said colloidal catalytic layer is a tin-palladium colloidal layer.

## Patentansprüche

1. Verfahren zur Herstellung einer gedruckten Schaltung, umfassend die Stufen der Bildung von Löchern in notwendigen Teil eines kupferbelegten Laminats, Bildung einer kolloidalen katalytischen Schicht auf den Lochwänden und der Kupferbelegung, Bildung eines ätzbeständigen Resistfilms auf den benötigten Flächen, der Leitungsanordnung und der Schaltung, Entfernung der Kupferbelegung auf dem nicht benötigten Teil durch Ätzen, Entfernung des ätzbeständigen Resistfilms, Aktivierung der kolloidalen katalytischen Schicht als Vorbehandlung für stromlose Plattierung und Bildung eines stromlos plattierten Films aus Kupfer oder Nickel auf der auf den Lochwänden, benötigten Flächen, der Leitungsanordnung und den Schaltungen gebildeten aktivierten katalytischen Schicht.

2. Verfahren nach Anspruch 1, worin der genannte stromlos plattierte Film auf der auf der Lochwänden gebildeten katalytischen Schicht nach der Durchführung des Ätzens und ohne Entfernung des ätzbeständigen Resistfilms gebildet wird.

3. Verfharen nach Anspruch 2, worin der ätzbeständige Resistfilm entfernt wird, nachdem der stromlos plattierte Film gebildet worden ist.

4. Verfahren nach irgendeinem der Ansprüche 1 bis 3, worin ein lötbeständiger Resistfilm auf dem benötigten Teil vor oder nach der Bildung des stromlos plattierten Films gebildet wird.

5. Verfahren nach irgendeinem der Ansprüche 1 bis 4, worin die genannte kolloidale katalytische Schicht eine kolloidale Zinn-Palladium-Schicht ist.

## Revendications

1. Procédé de fabrication d'une plaque de circuit imprimé comprenant les étapes consistant à: faire des trous dans la partie nécessaire d'un stratifié revêtu de cuivre; former une couche catalytique colloïdale sur les parois de ces trous et le revêtement de cuivre, former une pellicule de réserve de gravure sur les pastilles, conducteurs et circuits nécessaires; éliminer le revêtement de cuivre sur la partie non nécessaire par gravure; éliminer la pellicule de réserve de gravure, activer la couche catalytique colloïdale comme prétraitement pour la métallisation non galvanique; et former une pellicule de cuivre ou de nickel par voie non galvanique sur la couche catalytique activée formée sur les parois des trous, les pastilles, les conducteurs et les circuits.

2. Procédé suivant la revendication 1, dans lequel la pellicule métallisée par voie non galvanique est formée sur la couche catalytique formée sur les parois des trous après la gravure et sans éliminer la pellicule de réserve de gravure.

3. Procédé suivant la revendication 2, dans lequel la pellicule de réserve de gravure est éliminée après la formation de la pellicule métallisée par voie non galvanique.

4. Procédé suivant l'une quelconque des revendications 1 à 3, dans lequel une pellicule de réserve de brasage est formée sur la partie nécessaire avant ou après la formation de la pellicule métallisée par voie non galvanique.

5. Procédé suivant l'une quelconque des revendications 1 à 4, dans lequel la couche catalytique colloïdale est une couche colloïdale étain-palladium.

5

# FIG. 1

# FIG. 2

# FIG. 3

# FIG. 4

# FIG. 5

# FIG. 6

# FIG. 6'

## FIG. 7

3  7  4  2

1

## FIG. 7'

3  7  4

2  1

## FIG. 7"

3  5  2

4  1

7

## FIG. 8

3  4  2

1

7